(19) **Europäisches Patentamt**

**European Patent Office**

**Office européen des brevets**

(11) **EP 0 904 216 B1**

(12) **EUROPÄISCHE PATENTSCHRIFT**

(45) Veröffentlichungstag und Bekanntmachung des Hinweises auf die Patenterteilung:
**30.10.2002 Patentblatt 2002/44**

(51) Int Cl.⁷: **B60R 16/02**, H05K 5/06

(21) Anmeldenummer: **98920528.1**

(86) Internationale Anmeldenummer:
**PCT/EP98/02212**

(22) Anmeldetag: **15.04.1998**

(87) Internationale Veröffentlichungsnummer:
**WO 98/046458 (22.10.1998 Gazette 1998/42)**

(54) **GEHÄUSE FÜR ELEKTRISCHE BAUELEMENTE**

HOUSING FOR ELECTRIC COMPONENTS

BOITIER POUR COMPOSANTS ELECTRIQUES

(84) Benannte Vertragsstaaten:
**DE ES FR GB IT SE**

(30) Priorität: **15.04.1997 DE 19715573**

(43) Veröffentlichungstag der Anmeldung:
**31.03.1999 Patentblatt 1999/13**

(73) Patentinhaber: **Conti Temic microelectronic GmbH**
**90411 Nürnberg (DE)**

(72) Erfinder:
• **BAUR, Richard**
**D-85276 Pfaffenhofen (DE)**
• **FENDT, Günter**
**D-86529 Schrobenhausen (DE)**
• **WÖRLE, Engelbert**
**D-86556 Kühbach (DE)**

(74) Vertreter: **Kolb, Georg**
**DaimlerChrysler AG,**
**Postfach 35 35**
**74025 Heilbronn (DE)**

(56) Entgegenhaltungen:
EP-A- 0 248 181      WO-A-84/01082
DE-A- 2 718 563      DE-A- 3 107 694
DE-A- 4 329 055      DE-A- 4 329 980
DE-A- 19 505 125

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung **betrifft** ein Gehäuse für ein elektrisches oder elektronisches Bauelement, insbesondere eines Kraftfahrzeug-Steuergerätes, gemäß dem Oberbegriff des Patentanspruchs 1.

In der Regel werden elektrische und elektronische Bauelemente insbesondere elektronische Steuergeräte zum Schutz vor äußeren Einflüssen wie z.B. mechanische Einwirkungen, Staub und Feuchtigkeit in ein Gehäuse eingebaut. Die Anforderungen an dieses Gehäuse sind beim Einsatz im Kraftfahrzeug besonders hoch. Derartige Gehäuse müssen die empfindliche Elektronik vor Feuchtigkeit schützen, die in flüssiger Form als Wasser oder gasförmig als Wasserdampf in das Gehäuse eindringen kann. Die Gehäuse bestehen in der Regel zumindest teilweise aus einem thermoplastischen Kunststoff. Diese Kunststoffteile sind zwar wasserdicht jedoch nicht gasdicht, so daß Wasser in gasförmiger Form eindringen kann. Wird ein mehrteiliges Gehäuse durch entsprechende Dichtungen wasserdicht verschlossen, so kann zwar keine Flüssigkeit jedoch aber Gas in das Innere des Gehäuses eindringen. Es gilt dann:

$$Q = P * \frac{A*t}{d}$$

Q:     Hindurchtretende Gasmenge in $cm^3$ oder Wasserdampfmenge in g
A:     Oberfläche in $cm^2$
t:     Einwirkzeit in Tagen
d:     Wandstärke in cm
P:     Permeationskonstante in $cm^2/t$ (Gas) bzw. g/(cm*t) (Wasserdampf)

Unterscheidet sich aber der Druck außerhalb des Gehäuses vom dem Druck, der im Gehäuse herrscht, und der vor allem dadurch zustande kommt, daß sich die Temperaturen im und um das Gehäuse unterscheiden, dann gelangt Luft in das Gehäuseinnere. Es gilt dann:

$$Q = P * \frac{A*t*\delta p}{d}$$

Q:     Hindurchtretende Gasmenge in $cm^3$ oder Wasserdampfmenge in g
A:     Oberfläche in $cm^2$
t:     Einwirkzeit in Tagen
$\delta$ p:     Druckdifferenz in cm Quecksilbersäule
d:     Wandstärke in cm
P:     Permeationskonstante in cm/t (Gas) bzw. $g/(cm^2*t)$ (Wasserdampf)

Die Luft enthält aber auch gasförmigen Wasserdampf, der wegen seiner kleineren Teilchengröße durch den Kunststoff hindurch aufgrund der Druckdifferenz in das Gehäuse eindringt. Bei folgenden Parametern kann sich im Kraftfahrzeug-Bereich eine nicht vernachlässigbare Wassermenge im Gehäuse ansammeln. Es gilt bei 85% relative Luftfeuchtigkeit außen und 0% relative Luftfeuchtigkeit innen bei einer Temperatur von 20°C und 1 bar Luftdruck.
P = 2,1 $10^{-6}$ g/($cm^2$ t) für Polybutylenterephthalat
A = 32 $cm^2$
d = 1,5 mm
t = 15 Jahre = 5475 Tage wobei:

| 10% Betriebszeit (547,5 Tage) bei 20°C | keine Druckdifferenz |
|---|---|
| 20% Betriebszeit (1095 Tage) bei 40°C | $\delta$ p = 0,068 bar = 5,17 cm |
| 50% Betriebszeit (2737,5 Tage) bei 60°C | $\delta$ p = 0,137 bar = 10,41 cm |
| 20% Betriebszeit (1095 Tage) bei 80°C | $\delta$ p = 0,2 bar = 15,2 cm |

$$Q_{Gesamt} = Q_{20°C} + Q_{40°C} + Q_{60°C} + Q_{80°C} = 0,25g + 2,5g + 12,8g + 7,5g = 23g$$

Das heißt über die gesamte Lebensdauer eines Kraftfahrzeuges können im schlechtesten Fall 23 g Wasser durch ein Kunststoffgehäuseteil mit einer Fläche von 32 $cm^2$ und einer Stärke von 1,5 mm eindringen. Das kondensierte Wasser kann erhebliche Schäden an der Elektronik anrichten. Sie verändert z.B. die Leitfähigkeit zwischen den verschiedenen Komponenten, was zu Kurzschlüssen führen kann und verursacht die Oxidation also das Rosten von Kontakten. Aus diesen Gründen wurden bisherige Gehäuse mit sogenannten Druckausgleichsöffnungen versehen, an denen ein Druckausgleich zwischen dem Gehäuseinnern und der Umgebung stattfinden kann. Um an diesen Gehäuseöffnungen das Eindringen von Wasser zu verhindern, wurden diese mit einer wasserdichten und atmungsaktiven Folie verschlossen, so daß die elektronische Schaltung vor Wasser- oder Feuchteschäden bewahrt wird. Dieser Stand der Technik wird in der DE 197 08 116 A1 wiedergegeben.

**Nachteilig** hierbei ist jedoch, daß für das Zukleben der Druckausgleichsöffnungen mit der wasserdichten und atmungsaktiven Folie ein zusätzlicher Arbeitsschritt benötigt wird. Derartige wasserdichte und atmungsaktive Folien sind sehr teuer. Ein weiterer Nachteil bei derartigen Folien besteht darin daß sie zwar die Diffusionsrate durch den Druckausgleich vermindern aber auch für Wasserdampf durchlässig sind.

Die DE 27 18 563 A1 beschreibt ein wasserdichtes Gehäuse zum Schutz von Elektronikschaltkreisen mit zwei Behältern und einem Verschluß. In dieser Anordnung ist ein elastischer Behälter in einem starren Behälter angeordnet. Beide Behälter weisen einen gemeinsamen Verschluß auf, der beide Behälter wasserdicht verschließt. Bei diesem Aufbau sind Dichtungsmittel zwischen dem Verschluß und den beiden Behältern angeordnet. Diese Dichtungsmittel sind am offenen Ende des elastischen Behälters angebracht und werden zwischen dem starren Behälter und dem Verschluß eingeklemmt. Der Druckausgleich wird durch den elastischen Behälter erzielt, der innerhalb des starren Behälter sein Volumen vergrößern und verkleinern kann.

**Nachteilig** hierbei ist jedoch, dass zumindest ein Gehäuseteil elastisch sein bzw. elastische Teilbereiche aufweisen muß. Derartige Gehäuse sind aufwendig in der Herstellung und bieten geringen mechanischen Schutz.

Der Erfindung liegt daher die **Aufgabe** zugrunde ein Gehäuse der eingangs genannten Art zu schaffen, das eine Alternative zu dem kostenintensiven elastischen Gehäuseteil darstellt. Eine weitere Aufgabe besteht darin die Anzahl der Gehäuseteile zu erniedrigen und trotzdem einen hohen mechanischen Schutz für die elektrischen oder elektronischen Bauelemente zu gewährleisten.

Die Aufgabe wird erfindungsgemäß durch die Merkmale im Kennzeichen des Patentanspruches 1 **gelöst**. Das veränderbare Gehäuseinnenvolumen läßt sich dadurch realisieren, daß sich die Gehäuseteile untereinander verschieben lassen.

Die mit der Erfindung erzielten **Vorteile** bestehen darin, daß in ein solches Gehäuse keine Flüssigkeit und kein Gas bedingt durch Druckdifferenzen eindringen kann. Die elektrischen und elektronischen Komponenten werden zuverlässig im Innern des Gehäuses vor schädlichen Umgebungseinflüssen geschützt ohne das zusätzliche Druckausgleichsvorrichtungen benötigt werden. Gleichzeitig wird die Lebensdauer derart gehäuster Bauelemente stark vergrößert. Basierend auf den vorhergehenden Berechnungen würden jetzt nur noch 2,5g anstatt 23 g Wasser in das Gehäuse gelangen.

**Vorteilhafte Weiterbildungen** der Erfindung ergeben sich aus den abhängigen Ansprüchen. Hierbei ist eine Klebverbindung oder Dichtung elastisch wodurch sich die Gehäuseteile untereinander verschieben können und so das Gehäusevolumen verändern. Den gleichen Effekt, nämlich ein variables Gehäuseinnenvolumen wird auch dadurch erzielt, daß ein Stecker, welcher das Gehäuse verschließt, beweglich in einer Steckvorrichtung im Gehäuse angebracht ist, so daß er hin und her geschoben werden kann.

Mehrere Vergleichs- bzw. **Ausführungsbeispiele** der Erfindung sollen anhand den Figuren 1 bis 5 dargestellt werden.

Es zeigen:

**Figur 1a:** Seitenansicht eines Gehäuses mit Druckausgleichskörper, die nur der Erläuterung dient, jedoch nicht zur Erfindung gehört

**Figur 1b:** Schnittdarstellung eines Druckausgleichskörpers, die nur der Erläuterung dient, jedoch nicht zur Erfindung gehört

**Figur 2:** Schnittdarstellung eines Gehäuses mit beweglichem Isolierring

**Figur 3:** Schnittdarstellung eines Gehäuses mit beweglicher Isolierdichtlippe

**Figur 4a:** Schnittdarstellung eines Gehäuses mit elastischem Kleber oder Dichtmaterial

**Figur 4b:** Vereinfachte Schnittdarstellung eines Gehäuses mit elastischem Kleber oder Dichtmaterial

**Figur 5a:** Schnittdarstellung eines Gehäuses mit verformbaren Gehäuseteil bei identischem Innen- und Außendruck

**Figur 5b:** Schnittdarstellung eines Gehäuses mit verformbaren Gehäuseteil bei Unterdruck im Gehäuseinnern

**Figur 5c:** Schnittdarstellung eines Gehäuses mit verformbaren Gehäuseteil bei Überdruck im Gehäuseinnern

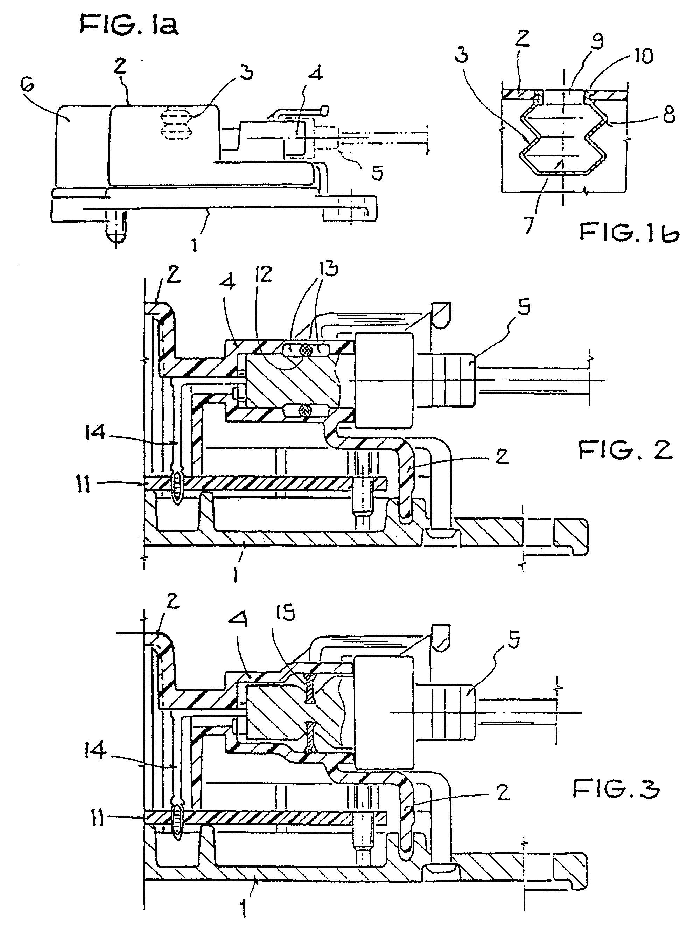

**Figur 1a** zeigt die Seitenansicht eines Gehäuses **6** mit Druckausgleichskörper **3**. Das Gehäuse **6** besteht zum einen aus einem thermoplastischen Kunststoffbehälter **2**, gefertigt aus z.B. Polybutylenterephthalat (PBT). Dieser Kunststoff ist für Flüssigkeiten insbesondere Wasser undurchlässig, jedoch kann er von gasförmige Stoffen durchdrungen werden. Diese Lösungsdiffusion läuft in drei Stufen ab. Zuerst wird der diffundierende Stoff an der Oberfläche der Seite mit der höheren Stoffkonzentration aufgenommen. Dann wandert der aufzunehmende Stoff von der Seite der höheren Konzentration in Richtung der Seite mit der niedrigen Konzentration, innerhalb des Kunststoffmaterials. Zum Schluß erfolgt die Ausscheidung des vom Kunststoffmaterial aufgenommenen Stoffes auf der Seite mit niederer Stoffkonzentration. Die Lösungsdiffusion ist wie bereits beschrieben abhängig von den Druckverhältnissen zwischen Innen- und Außenwand.

Weiterhin beinhaltet dieses Gehäuse **6** einen Boden **1** der den Kunststoffbehälter **2** von unten verschließt. Dieser Boden **1** kann aus Metall oder Kunststoff bestehen. Weiterhin beinhaltet der Behälter **2** eine im Bereich der Kontakte offenen Steckervorrichtung **4**. Diese Stelle wird mit Hilfe eines Steckers **5** verschlossen. Weiterhin ist am Behälter ein Druckausgleichskörper **3** angebracht, dessen Größe und Form sich in Abhängigkeit von den herrschenden Druckdifferenzen verändern kann. Dieser Druckausgleichskörper **3** ist ziehharmonikaförmig aufgebaut, wie die Detaildarstellung des Druckausgleichskörpers **3** in **Figur 1b** zeigt. Der Druckausgleichskörper **3** besteht aus einem gummiartigen Material **8** und verschließt eine Öffnung **9** im Behälter **2** durch einen Formschluß **10**. Außerdem ragt der Druckausgleichskörper **3** in das Innere des Behälters **2** wo er je nach Eigenvolumen **7** mehr oder weniger Platz beansprucht. Dieses Eigenvolumen **7** ist abhängig von den Druckverhältnissen, denn durch den ziehharmonikaförmigen Aufbau verändert sich die Form bei Krafteinwirkung und zieht sich zusammen oder auseinander. Bei einem derartigen Druckausgleichskörper spielt es keine Rolle ob er in das Innere des Gehäuses ragt oder nach außen absteht oder an welchem Gehäuseteil er angebracht ist. Von Bedeutung ist nur, daß er das Gehäuseinnenvolumen verändert indem er seine Form verändert, wobei es unbedeutend ist welche Form der Druckausgleichsbehälter tatsächlich hat. Anstatt einem ziehharmonikaförmigen Aufbau kann der Druckausgleichskörper als Ballon ausgeführt werden der je nach Druck seine Größe verändert.

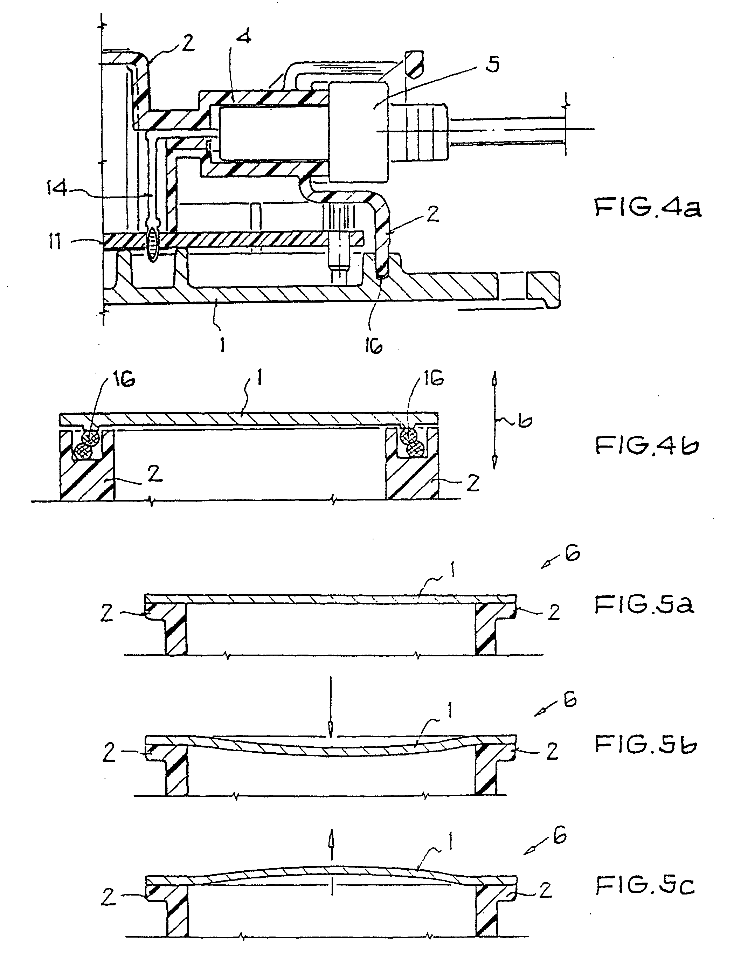

**Figur 2** zeigt ein weiteres Anwendungsbeispiel. Dargestellt ist ein Schnitt durch das Gehäuse, welches einen beweglichen Isolierring **12** im Steckerbereich **4** aufweist. Auch in diesem Ausführungsbeispiel besteht das Gehäuse aus einem Behälter **2** mit einer Steckvorrichtung **4**. Im Behälter befindet sich auf einer Platine **11** die zu schützende Elektronik. Diese wird über Kontaktstifte **14** mit dem Stecker **5** verbunden. Als Verschluß des Behälters dient ein Boden **1**, der den Behälter von unten verschließt und ein Stecker **5** der den Behälter **2** in der Steckvorrichtung **4** abdichtet. Der Dichtring **12** gestattet es, daß sich der Stecker **5** in der Steckvorrichtung **4** hin und her bewegen läßt und dabei gleichzeitig das Gehäuse wasserdicht oder je nach Material gasdicht verschließt. Der Dichtring **12** kann sowohl fest in der Steckvorrichtung **4** oder am Stecke **5** angebracht sein oder wie abgebildet beweglich in einer Führung **13** gelagert sein. Bei diesem Ausführungsbeispiel ist es nur von Bedeutung, daß sich der Stecker **5** oder ein anderer Verschluß in der Steckvorrichtung **4** oder einer anderen Verschlußvorrichtung bewegen läßt, ohne daß die Dichtigkeit nach außen verloren geht. Weiter ist es wichtig, daß sich durch die Hin- und Her- Bewegung des Steckers **5**, das Gehäuseinnenvolumen verändert und diese Hin- und Her-Bewegung von der Druckdifferenz gesteuert wird, so daß ein Druckausgleich zwischen dem Gehäuseinnern und der Umgebung erfolgen kann. Auf diesem Prinzip beruht auch das in **Figur 3** dargestellte Ausführungsbeispiel. Hier wird die Beweglichkeit des Steckers **5** in der Steckvorrichtung **4** unter Aufrechterhaltung der Dichtigkeit durch eine bewegliche Dichtlippe **15** gewährleistet. Diese Dichtlippe ist zweckmäßigerweise an der Steckvorrichtung oder am Stecker befestigt. Weiterhin ist die Lippe breit und elastisch genug, daß sie sich bei einer Steckerbewegung an die Innenwand der Steckvorrichtung schmiegt und das Gehäuse an dieser Stelle zuverlässig abdichtet. Bevorzugtes Materialien für die Dichtlippe und den Dichtring sind gummiartige Stoffe. Eine weitere Ausführungsform, die einen Druckausgleich durch die Anpassung des Gehäuseinnenvolumens erlaubt ist in Figur 4a und 4b dargestellt. **Figur 4a** zeigt gleichfalls das Gehäuse, dessen Behälter durch die Bodenplatte **1** und den Stecker **5** verschlossen wird und die zu schützende Elektronik beinhaltet. Hier besteht die Vorrichtung, die die Volumenanpassung im Gehäuseinnern an die bestehenden Druckverhältnisse bewirkt, aus einem elastischen Kleber oder einer elastischen Dichtmasse **16** zwischen Boden **1** und Behälter **2.** Dieser Kleber bzw. diese Dichtmasse ist dehnbar und zäh und bleibt auch unter Krafteinwirkung am Boden **1** und am Behälter **2** haften, so daß auch dieser bewegliche Verschluß zuverlässig dicht ist. Dieser Sachverhalt ist nochmals in **Figur 4b** dargestellt. Durch den elastischen Kleber bzw. der elastischen Dichtmasse **16** ist eine Auf- und Abbewegung des Bodens **1,** eines Deckels oder anderen Verschlusses bzw. des Behälters **2** in Richtung des Pfeils möglich. Hierbei verändert sich das Innenvolumen bis ein Druckausgleich geschaffen ist.

Eine andere Möglichkeit den Druckausgleich durch Volumenanpassung im Gehäuseinnern zu erzielen ist im Ausführungsbeispiel der Figuren 5a, 5b und 5c dargestellt. Hier ist ein Gehäuse abgebildet, bei dem zumindest ein Gehäuseteil bzw. ein Verschluß dehnbar ist. **Figur 5a** zeigt den ausgeglichenen Zustand bei dem im Gehäuseinnern die Temperatur und der Druck identisch ist mit den Umgebungsbedingungen außerhalb des Gehäuses **6**. Auf den Boden **1** oder ein anderes Gehäuseteil wirkt keine Kraft. Sinkt nun die Temperatur im Gehäuseinnern oder steigt die Temperatur außerhalb des Gehäuses so entsteht ein Unterdruck und der dehnbare Boden **1** oder ein anderes Gehäuseteil verformt sich nach innen und reduziert das Innenvolumen solange bis der Druckausgleich erzielt ist. Steigt dagegen die Temperatur im Gehäuseinnern oder sinkt die Temperatur außerhalb des Gehäuses so entsteht ein Überdruck und der dehnbare Boden **1** oder ein anderes Gehäuseteil verformt sich nach außen bis das Volumen so groß ist, daß der Druck im Gehäuseinnern und der Druck außerhalb des Gehäuses **6** konstant bleibt.

# EP 0 904 216 B1

## Patentansprüche

1. Gehäuse (6) für ein elektrisches oder elektronisches Bauelement, insbesondere eines Kraftfahrzeug-Steuergerätes, bestehend aus einem ein- oder mehrteiligen Behälter (2) und einem oder mehreren ein- oder mehrteiligen Verschlüssen (1, 5), wobei der Behälter (2) mit dem Verschluß (1, 5) durch Dichtungsmittel (12, 15, 16) wasserdicht verschlossen ist
**dadurch gekennzeichnet, daß**
der Verschluß (1, 5) beweglich mit dem Behälter (2) verbunden ist und eine Hin- und Her-Bewegung zwischen Behälter (2) und Verschluß (1,5) zur Änderung des Innenvolumens gestattet.

2. Gehäuse nach Patentanspruch 1, **dadurch gekennzeichnet, daß** mindestens eine Verbindung des mehrteiligen Behälter (2) oder des mehrteiligen Verschlusses (1, 5) oder eine Verbindung zwischen Behälter (2) und Verschluß (1,5) durch einen elastischen Kleber (16) erzielt wird oder durch eine elastische Dichtmasse (16, 15, 12) abgedichtet wird, wodurch die Gehäuseteile bewegbar miteinander verbunden sind und eine Veränderung des Gehäusevolumens ermöglichen.

3. Gehäuse nach Patentanspruch 1, **dadurch gekennzeichnet, daß** der Verschluß ein Stecker (5) ist, der innerhalb einer Steckvorrichtung hin und her geschoben werden kann.

## Claims

1. A housing (6) for an electrical or electronic component, in particular, a motor vehicle control device, consisting of a single or multi-part container (2) and one or more single or multi-part closure members (1, 5), wherein the container (2) is closed by the closure member (1, 5) in water-tight manner by sealing means (12, 15, 16),
**characterised in that**
the closure member (1, 5) is connected to the container (2) in moveable manner and a backward and forward movement between the , container (2) and the closure member (1, 5) is permitted for the purposes of altering the interior volume.

2. A housing in accordance with Claim 1, **characterised in that** at least one connection of the multi-part container (2) or of the multi-part closure member (1, 5) or a connection between the container (2) and the closure member (1, 5) is obtained by means of a resilient adhesive (16) or is sealed by means of a resilient sealing mass (16, 15, 12), whereby the housing parts are connected together in moveable manner and enable the volume of the housing to be altered.

3. A housing in accordance with Claim 1, **characterised in that** the closure member is a plug (5) which can be displaced backwardly and forwardly within a connector device.

## Revendications

1. Boîtier (6) pour un composant électrique ou électronique, en particulier d'un appareil de commande de véhicule automobile, constitué par un récipient (2) en une ou en plusieurs pièces et par une ou plusieurs fermetures (1, 5) en une ou en plusieurs pièces, le récipient (2) étant refermé avec la fermeture (1, 5) de façon étanche à l'eau à l'aide de moyens d'étanchement (12, 15, 16),
**caractérisé en ce que** la fermeture (1, 5) est reliée de façon mobile au récipient (2) et permet un mouvement en va-et-vient entre le récipient (2) et la fermeture (1, 5) pour modifier le volume interne.

2. Boîtier selon la revendication 1, **caractérisé en ce qu'**au moins une liaison du récipient (2) en plusieurs pièces ou de la fermeture (1, 5) en plusieurs pièces ou une liaison entre le récipient (2) et la fermeture (1, 5) est obtenue par une colle élastique (16) ou étanchée par une masse d'étanchement élastique (16, 15, 12), les pièces du boîtier étant reliées de façon mobile les unes aux autres et permettant une modification du volume du boîtier.

3. Boîtier selon la revendication 1, **caractérisé en ce que** la fermeture est une fiche (5) qui est mobile en va-et-vient à l'intérieur d'un dispositif d'enfichage.

FIG. 1a

FIG. 1b

FIG. 2

FIG. 3

FIG.4a

FIG.4b

FIG.5a

FIG.5b

FIG.5c